Europäisches Patentamt

European Patent Office

Office européen des brevets

(19)

(11) Veröffentlichungsnummer: **0 045 058**
**B1**

(12) # EUROPÄISCHE PATENTSCHRIFT

(45) Veröffentlichungstag der Patentschrift:
28.10.87

(51) Int. Cl.⁴: **H 01 G  4/30**

(21) Anmeldenummer: **81105804.9**

(22) Anmeldetag: **22.07.81**

(54) Verfahren und Vorrichtung zur Herstellung von Schichtkondensatoren.

(30) Priorität: **24.07.80  DE 3028123**

(43) Veröffentlichungstag der Anmeldung:
**03.02.82 Patentblatt 82/5**

(45) Bekanntmachung des Hinweises auf die Patenterteilung:
**28.10.87 Patentblatt 87/44**

(84) Benannte Vertragsstaaten:
**DE FR GB IT SE**

(56) Entgegenhaltungen:
**DE - A - 2 847 620**
**DE - A - 2 900 772**

(73) Patentinhaber: **Siemens Aktiengesellschaft Berlin und München, Wittelsbacherplatz 2, D-8000 München 2 (DE)**

(72) Erfinder: **Behn, Reinhard, Dipl.-Phys.,
Frasdorferstrasse 6 d, D-8000 München 90 (DE)**

**Beschreibung**

Die vorliegende Erfindung betrifft ein Verfahren zur Herstellung von Schichtkondensatoren, bei dem Träger in Vertiefungen einer Trommel befestigt werden, bei dem die Träger auf dieser Trommel abwechselnd durch zwei Vakuumkammern geführt werden, bei dem in einer dieser Vakuumkammern Metallschichten aufgedampft und in der zweiten Vakuumkammer Isolierstoffschichten aufgebracht werden. Ein derartiges Verfahren ist aus der DE-OS 2 847 620 bekannt. Dort werden in einer Vakuumkammer Metallschichten aufgedampft und in der zweiten Vakuumkammer Glimmpolymerisatschichten erzeugt. Die beiden Vakuumkammern sind durch Vakuumschleusen voneinander getrennt, wobei Stege des Trommelumfanges zwischen Vertiefungen der Trommel zusammen mit äusseren Schleusenbacken die Vakuumschleusen bilden. Die erste Vakuumkammer enthält eine feste Blende, welche die Bedampfungsfläche genau begrenzt.

Die Aufgabe, die der vorliegenden Erfindung zugrundeliegt, besteht bei einem Verfahren der eingangs beschriebenen Art darin, dass alle Metallschichten gleichmässig und gleich dick aufgebracht werden sollen.

Diese Aufgabe wird erfindungsgemäss dadurch gelöst, dass der Dampfstrahl vor der Bedampfung durch eine Abschirmblende abgeschirmt wird, dass die Trommel in Drehung versetzt wird, dass nach Erreichen der eingestellten Drehzahl der Trommel die Abschirmblende in der Zeitspanne aus dem Dampfstrahl entfernt wird, in der ein Stellbereich auf dem Trommelumfang die Bedampfungszone durchläuft und dass die Abschirmblende nach der Herstellung der letzten Metallschicht während des Durchlaufens desselben Stellbereiches wieder in den Dampfstrahl eingeführt wird.

Dieses Verfahren hat den Vorteil, dass einerseits während des Einsetzens der Trommel bzw. während der Bestückung der Trommel mit Trägern keine Bedampfung stattfindet, dass andererseits der Verdampfer bereits vor der Bedampfung auf seine optimale Temperatur aufgeheizt werden kann und dass während des Entfernens bzw. während des Einführens der Abschirmblende stets der gleiche Bereich des Umfanges der Trommel sich in der Bedampfungszone befindet. Dadurch wird erreicht, dass nur in diesem Stellbereich ungleichmässige Schichten entstehen. Die im Stellbereich entstandenen Schichten können dann ohne Schwierigkeiten von einer Weiterverarbeitung zu Kondensatoren ausgeschlossen werden.

Ein geringer ungenutzter Anteil des Trommelumfanges ohne eine unzulässige Erhöhung des Aufwandes für die Steuerung und Bewegung der Abschirmblende ist gewährleistet, wenn der Stellbereich nur eine Vertiefung enthält. In diesem Fall ist es besonders vorteilhaft, wenn in der Vertiefung im Stellbereich Messeinrichtungen zur Überwachung der Qualität untergebracht werden und wenn Messungen nach dem Aufbringen der zweiten und vor dem Aufbringen der letzten Metallschicht durchgeführt werden. So wird in dem Stellbereich eine einwandfreie Überwachung der Schichtqualitäten ermöglicht, da nur die erste und die letzte Metallschicht ungleichmässig und daher für eine Überwachung unbrauchbar werden.

Das vorgeschlagene Verfahren wird vorteilhaft in einer Vorrichtung durchgeführt, in der zwischen den Vertiefungen achsparallele Stege des Trommelumfanges liegen, in der diese Stege zusammen mit Schleusenbacken Vakuumschleusen bilden, welche zwei Vakuumkammern voneinander trennen, wobei diese Vorrichtung eine feste Blende enthält, welche die bedampfte Fläche genau begrenzt, wobei die Gesamtausdehnung zumindest einer Vertiefung zusammen mit den beiden angrenzenden Stegen grösser ist, als die in Drehrichtung der Trommel grösste Ausdehnung der festen Blende, wobei sie eine Abschirmblende enthält, wobei die genannte Vertiefung und die angrenzenden Stege einen Stellbereich für die Abschirmblende bestimmen, wobei Steuereinrichtungen vorgesehen sind, welche die Abschirmblende aus dem Dampfstrahl entfernen bzw. nach der letzten Bedampfung wieder in den Dampfstrahl einführen, wobei diese Steuereinrichtungen die Bewegung der Blende auslösen, wenn der in der Drehrichtung der Trommel vor der im Stellbereich liegenden Vertiefung befindliche Steg die Blendenöffnung der festen Blende mit einer ersten seiner Kanten überschritten hat und in der das Entfernen bzw. Einführen der Abschirmblende beendet ist, wenn der in Drehrichtung hinter der Vertiefung im Stellbereich liegende Steg mit seiner letzten Kante die Blendenöffnung der festen Blende erreicht hat.

Durch diese Phasenlage der Bewegung der Abschirmblende wird einerseits der Stellbereich auf eine Vertiefung begrenzt und andererseits der Bereich voll ausgenützt, in dem keine Störung der Metallisierung in den benachbarten Vertiefungen eintritt. Dadurch wird der Aufwand für die Steuerung relativ klein gehalten, was insbesondere bei hohen Drehgeschwindigkeiten der Trommel von Bedeutung ist.

Vorteilhaft sind in der vorgeschlagenen Vorrichtung in der im Stellbereich befindlichen Vertiefung Messeinrichtungen zur Überwachung der Qualität der Metallschichten und/oder der Dielektrikumsschichten untergebracht. Besonders vorteilhaft wird die Schichtdicke der aufgedampften Belagflächen und/oder der Dielektrikumsschichten gemessen, und die Messwerte werden einer Steuereinrichtung zugeführt, welche bei Abweichungen von Sollwerten automatisch eine Korrektur für die folgenden Schichten auslöst.

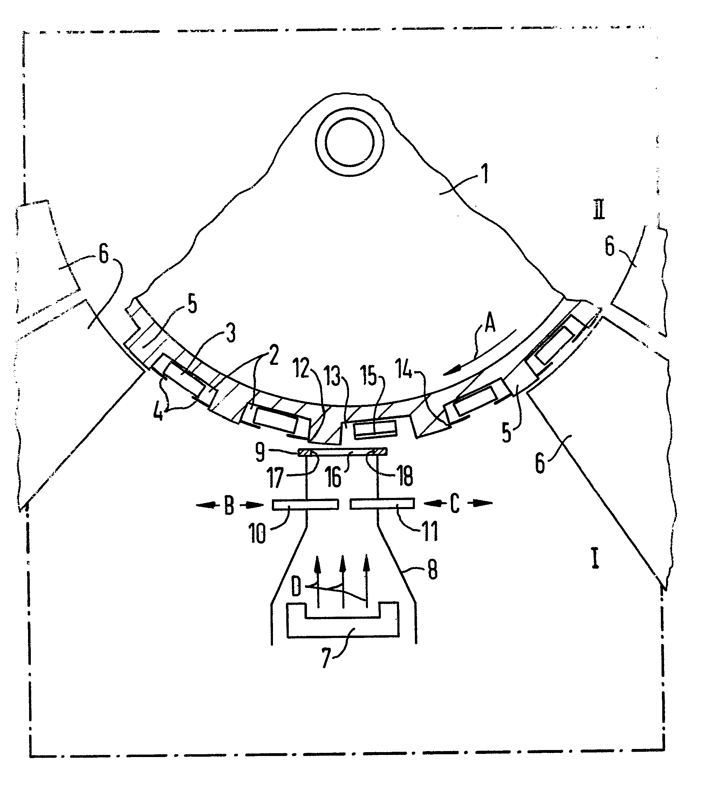

Die Erfindung wird nun anhand einer Figur näher erläutert. Sie ist nicht auf das in der Figur gezeigte Beispiel beschränkt. Die Figur zeigt eine erfindungsgemässe Vorrichtung schematisch in teilweise gebrochener Ansicht.

Eine Trommel 1 weist Vertiefungen 2 auf. In den Vertiefungen 2 befinden sich Träger 3, deren nicht zu beschichtende Bereiche durch Blenden 4 abgedeckt sind. Die Trommel 1 durchläuft zwei Vakuumkammern I und II, welche durch Vakuumschleusen voneinander getrennt sind, die einerseits durch die Stege 5 der Trommel 1 und andererseits durch die Schleusenbacken 6 gebildet sind. In der Vakuumkammer I befindet sich ein Metallverdampfer 7, dessen Bedampfungsbereich durch ein Abschirmblech 8 und eine feststehende Blende 9 begrenzt ist.

Eine Abschirmblende wird durch die Blendenteile 10 und 11 gebildet, welche in den Pfeilrichtungen B und C aus dem Dampfstrahl, welcher in Pfeilrichtung D verläuft, entfernt und wieder in den Dampfstrahl eingeführt werden können.

Ein Stellbereich für die Bewegung der Blendenteile 10 und 11 liegt im Bereich einer bestimmten Vertiefung 13. Die Bewegung der Blendenteile, d.h. die Entfernung der Blendenteile aus dem Dampfstrahl bzw. das Einführen der Blendenteile in den Dampfstrahl, beginnt, sobald die erste Kante 12 des in Drehrichtung A der Trommel 1 vor der Vertiefung 13 liegenden Steges 5 die Blendenöffnung 16 der festen Blende 9 und somit die Kante 17 der Blendenöffnung 16 in allen Punkten überschritten hat. Die Bewegung der Blendenteile ist abgeschlossen, bevor die letzte Kante 14 des in Drehrichtung A der Trommel 1 hinter der Vertiefung 13 liegenden Steges 5 die Kante 18 der Blendenöffnung 16 in einem beliebigen Punkt erreicht hat. So ist gewährleistet, dass die Schichtdicke der Metallisierungen auf den Trägern 3 der benachbarten Vertiefungen 2 durch die Bewegung der Blendenteile 10 und 11 der Abschirmblende nicht beeinflusst wird.

In der Vertiefung 13 befinden sich Messeinrichtungen 15, welche vorzugsweise die Schichtdicke der aufgedampften Metallschichten und der aufgebrachten Isolierstoffschichten messen. Diese Messungen werden nach der Herstellung der zweiten Metallschicht und vor der Herstellung der letzten Metallschicht durchgeführt. So ist gewährleistet, dass die erste und die letzte Metallschicht nicht in die Messungen einbezogen werden, da diese durch das Entfernen bzw. Einführen der Abschirmblende unbrauchbar werden.

Die feste Blende 9 ist in unmittelbarer Nähe der Trommel 1 untergebracht, um eine exakte Begrenzung der Bedampfungszone zu gewährleisten. Die Abschirmblende kann dahinter angeordnet sein. Die Geschwindigkeit des Dampfstrahles ist so hoch, dass bei den technisch realisierbaren Abmessungen keine messbare Verzögerung der Beschichtung durch die Ausbreitung des Dampfstrahles eintritt.

Die Messeinrichtungen 15 in der Vertiefung 13 messen vorzugsweise die Schichtdicke der Metallisierungen. Nach diesen Messergebnissen steuern dann nicht dargestellte Steuereinrichtungen die Bedampfungsrate beispielsweise durch Regelung der Heizleistung im Verdampfer. Zur Bestimmung der Schichtdicke der Isolierstoffschichten können beispielsweise Reflexionsmessungen verwendet werden. Diese Messungen werden vorteilhaft im Bereich der Schleusenbacken 6 durchgeführt, da in diesem Zeitpunkt keine Beschichtung stattfindet. Unabhängig von der Lage der Messeinrichtungen zu den Schleusen 6 können die Messungen durchgeführt werden, wenn in der Vertiefung 13 ein Teststreifen beschichtet und nach jeder Beschichtung weitertransportiert wird. In diesem Fall können die Messungen ausserhalb der Bereiche des Teststreifens, die jeweils der Beschichtung ausgesetzt sind, durchgeführt werden.

**Patentansprüche**

1. Verfahren zur Herstellung von Schichtkondensatoren, bei dem Träger in Vertiefungen einer Trommel befestigt werden, bei dem die Träger auf dieser Trommel abwechselnd durch zwei Vakuumkammern geführt werden, bei dem in einer dieser Vakuumkammern Metallschichten aufgedampft und in der zweiten Vakuumkammer Isolierstoffschichten aufgebracht werden, dadurch gekennzeichnet, dass der Dampfstrahl vor der Bedampfung durch eine Abschirmblende abgeschirmt wird, dass der Träger in Drehung versetzt wird, dass nach Erreichen der eingestellten Drehzahl der Trommel die Abschirmblende in der Zeitspanne aus dem Dampfstrahl entfernt wird, in der ein Stellbereich auf dem Trommelumfang die Bedampfungszone durchläuft und dass die Abschirmblende nach der Herstellung der letzten Metallschicht während des Durchlaufens desselben Stellbereiches wieder in den Dampfstrahl eingeführt wird.

2. Verfahren nach Anspruch 1, dadurch gekennzeichnet, dass der Stellbereich nur eine Vertiefung enthält.

3. Verfahren nach Anspruch 2, dadurch gekennzeichnet, dass in der Vertiefung (13) im Stellbereich Einrichtungen (15) zur Überwachung der Schichtqualität untergebracht werden und dass Messungen nach dem Aufbringen der zweiten und vor dem Aufbringen der letzten Metallschicht durchgeführt werden und dass festgestellte Abweichungen von den Sollwerten bei den folgenden Schichten korrigiert werden.

4. Vorrichtung zur Durchführung des Verfahrens nach einem der Ansprüche 1 bis 3, in der zwischen Vertiefungen achsparallele Stege eines Trommelumfanges liegen, in der diese Stege zusammen mit Schleusenbacken Vakuumschleusen bilden, welche zwei Vakuumkammern voneinander trennen, wobei sie eine feste Blende (9) enthält, welche die Bedampfungsfläche genau begrenzt, dadurch gekennzeichnet, dass die Gesamtausdehnung zumindest einer Vertiefung (13) zusammen mit den beiden angrenzenden Stegen (5) grösser ist, als die in Drehrichtung (A) der Trommel (1) grösste Ausdehnung der festen Blende (9), dass sie eine Abschirmblende enthält, dass die genannte Vertiefung (13) und die angrenzenden Stege (5) einen Stellbereich für die Abschirmblende bestimmen, dass Steuereinrichtungen vorgesehen sind, welche die Abschirmblende aus dem Dampfstrahl entfernen bzw. nach der letzten Bedampfung wieder in den Dampfstrahl einführen, dass diese Steuereinrichtung die Bewegung der Blendenteile (10, 11) auslösen, wenn der in der Drehrichtung der Trommel (1) vor der im Stellbereich liegenden Vertiefung (13) befindliche Steg (5) die Blendenöffnung (16) der festen Blende (9) mit einer ersten Kante (12) überschritten hat und dass das Entfernen bzw. Einführen der Abschirmblende beendet ist, wenn der in Drehrichtung (A) hinter der Vertiefung (13) im Stellbereich liegende Steg (5) mit seiner letzten Kante (18) die Blendenöffnung (16) der festen Blende (9) erreicht hat.

5. Vorrichtung nach Anspruch 4, dadurch gekennzeichnet, dass in der im Stellbereich befindlichen Vertiefung Messeinrichtungen zur Überwachung der Qualität der Metallschichten und/oder der Dielektrikumsschichten untergebracht sind.

6. Vorrichtung nach Anspruch 5, dadurch gekennzeichnet, dass die Schichtdicke der aufgedampften Belagsflächen und/oder der Dielektrikumsschichten gemessen und dass die Messwerte einer Steuereinrichtung zugeführt werden, welche bei Abweichungen von einem entsprechenden Sollwert automatisch eine Korrektur für die folgenden Schichten auslöst.

7. Vorrichtung nach einem der Ansprüche 4 bis 6, dadurch gekennzeichnet, dass die Vertiefung (13) im Stellbereich einen Teststreifen enthält, dass dieser Teststreifen nach jeder Beschichtung weitertransportiert wird und dass die Messungen ausserhalb der Bereiche des Teststreifens, die jeweils der Beschichtung ausgesetzt sind, durchgeführt werden.

**Claims**

1. A process for the production of layered capacitors, in which carriers are secured in recesses in a drum, in which the carriers, on this drum, are alternately conducted through two vacuum chambers, in which metal layers are vapour deposited in one of said vacuum chambers and insulating layers are applied in the second vacuum chamber, characterised in that prior to the vapour deposition the vapour jet is screened by a screening diaphragm, that the carrier is set in rotation, that when the set drum speed has been reached the screening diaphragm is moved out of the vapour jet during the time in which a control zone on the drum periphery passes through the vaporisation zone and that when the last metal layer has been formed the screening diaphragm is reintroduced into the vapour jet during the passage of the same control zone.

2. A process as claimed in Claim 1, characterised in that the control zone contains only one recess.

3. A process as claimed in Claim 2, characterised in that devices (15) for monitoring the layer quality are accommodated in the recess (13) in the control zone, and that measurements are carried out following the application of the second metal layer and before the application of the last metal layer and that any deviations noted from theoretical values are corrected in the following layers.

4. A device for carrying out the process claimed in one of Claims 1 to 3, in which axially parallel ribs of a drum periphery are located between recesses, and in which said ribs, together with sealing jaws, form air locks which separate two vacuum chambers from one another, and where in the device contains a fixed diaphragm (9) which accurately delimits the vaporisation surface, characterised in that the total extent of at least one recess (13) together with the two adjoining ribs (5) is greater than the maximum extent of the fixed diaphragm (9) in the rotation direction (A) of the drum (1), that the device contains a screening diaphragm, that the aforesaid recess (13) and the adjacent ribs (5) define a control zone for the screening diaphragm, that control devices are provided which move the screening diaphragm out of the vapour jet and re-introduce it into the vapour jet after the last vaporisation, that this control device triggers the movement of the diaphragm component (10, 11) when a leading edge (12) of the rib (5) located in front of the recess (13) in the control zone considered in the direction of rotation of the drum (1) has crossed the diaphragm opening (16) of the fixed diaphragm (9), and that the removal or introduction of the screening diaphragm is terminated when the trailing edge (18) of the rib (5) situated behind the recess (13) in the control zone considered in the direction of rotation (A) has reached the diaphragm opening (16) of the fixed diaphragm (9).

5. A device as claimed in Claim 4, characterised in that measuring devices which serve to monitor the quality of the metal layers and/or the dielectric layers are accommodated in the recess located in the control zone.

6. A device as claimed in Claim 5, characterised in that the layer thickness of the vapour deposited coating layers and/or the dielectric layers is measured and that the measured values are supplied to a control device which, in the event of deviations from a corresponding theoretical value, automatically triggers a correction for the following layers.

7. A device as claimed in one of the Claims 4 to 6, characterised in that the recess (13) located in the control zone contains a test strip, that following each coating this test strip is moved onwards, and that the measurements are conducted outside of those zones of the test strip which are exposed to the coating.

**Revendications**

1. Procédé pour la fabrication de condensateurs à couches, dans lequel des supports sont fixés dans des cavités d'un tambour, dans lequel les supports montés sur ce tambour passent alternativement par deux chambres à vide, dans lequel, dans une de ces chambres, des couches métalliques sont déposées par évaporation, alors que dans la seconde chambre à vide sont déposées des couches d'une substance isolante, caractérisé par le fait que le jet de vapeur est, avant la métallisation sous vide, délimité à l'aide d'un diaphragme-écran, que le support est mis en rotation, qu'après que soit atteint le nombre de tours réglé du tambour, le diaphragme-écran est écarté du jet de vapeur dans l'intervalle de temps durant lequel une zone de réglage de la périphérie du tambour passe par la zone d'évaporation, et que le diaphragme-écran est à nouveau introduit dans le jet de vapeur après la réalisation de la dernière couche métallique, pendant le passage de la même zone de réglage.

2. Procédé selon la revendication 1, caractérisé par le fait que la zone de réglage ne comporte qu'une cavité.

3. Procédé selon la revendication 2, caractérisé par le fait que dans la cavité (13) de la zone de réglage, sont logés des dispositifs (15) pour surveiller la qualité de la couche, et que des mesures sont réalisés après le dépôt de la seconde métallique et avant le dépôt de la dernière couche métallique, et que des écarts déterminés par rapport aux valeurs de consigne, sont corrigés pour les couches suivantes.

4. Dispositif pour la mise en œuvre du procédé selon l'une des revendications 1 à 3, dans lequel, entre des cavités, se situent des barrettes d'une périphérie de tambour, qui sont parallèles à l'axe, dans lequel ces barrettes forment, avec des mâchoires de sas des sas à vide qui séparent, entre elles deux chambres à vide, du type dans lequel il est prévu un diaphragme fixe (9) qui délimite, de façon précise, la surface de métallisation sous vide, caractérisé par le fait que l'extension totale d'au moins une cavité (13), y compris les deux barrettes voisines (5), est supérieure à l'extension du diaphragme fixe (9) mesuré dans le sens de la rotation (A) du tambour (1), qui comporte un diaphragme-écran, que ladite cavité (13) et les barrettes avoisinantes (5) déterminent une zone de réglage pour le diaphragme-écran, que sont prévus des dispositifs de commande qui éloignent le diaphragme-écran du jet de vapeur et qui l'introduisent après la dernière métallisation sous vide dans le jet de vapeur, que ce dispositif de commande déclenche le déplacement des éléments de diaphragme (10, 11), lorsque la barrette (5) qui se trouve, dans le sens de la rotation du tambour (1), devant la cavité (13) qui se situe dans la zone de réglage, passe, avec un premier bord (12), au-delà de l'ouverture de diaphragme (16) du diaphragme fixe (9), et que l'écartement ou l'introduction du diaphragme-écran est terminée lorsque la barrette (5) qui se situe, dans le sens de rotation (A), derrière la cavité (13), dans la zone de réglage, a atteint, avec son dernier bord (18), l'ouverture de diaphragme (16) du diaphragme fixe (9).

5. Dispositif selon la revendication 4, caractérisé par le fait que dans la cavité qui se trouve dans la zone de réglage, sont logés des dispositifs de mesure pour contrôler la qualité des couches métalliques et/ou des couches de diélectrique.

6. Dispositif selon la revendication 5, caractérisé par le fait que l'épaisseur de couches des surfaces de revêtement déposées par métallisation sous vide et/ou les couches de diélectrique sont mesurées et que les valeurs de mesure sont appliquées à un dispositif de commande qui, lors d'écarts par rapport à une valeur de consigne correspondante, déclenche automatiquement une correction pour les couches suivantes.

7. Dispositif selon l'une des revendications 4 à 6, caractérisé par le fait que la cavité (13) dans la zone de réglage, comporte une bande de contrôle, que cette bande de contrôle est avancée après réalisation de chaque revêtement, et que les mesures sont réalisées en dehors des zones de la bande de contrôle, qui sont chacune exposées au revêtement.